# EUROPEAN PATENT APPLICATION

(11) **EP 4 604 166 A1**
(43) Date of publication of application: **20.08.2025**
(21) Application number: 25158631.9
(22) Date of filing: 18.02.2025
(51) Int. Cl.: H01J 37/26, H01J 37/28

(54) **SCANNING TRANSMISSION ELECTRON MICROSCOPE AND ALIGNING METHOD OF APERTURE**

(30) Priority: 19.02.2024 JP 2024022771
(71) Applicant: Jeol Ltd., Akishima-shi, Tokyo 196-8558 (JP)
(72) Inventor: HASHIGUCHI, Hiroki, Tokyo, 196-8558 (JP); JIMBO, Yu, Tokyo, 196-8558 (JP)
(74) Representative: Boult Wade Tennant LLP

(57) **Abstract**

A scanning transmission electron microscope includes an electron source that generates an electron beam, an optical system that has a condenser lens, an aperture, and an objective lens and forms an electron probe by condensing the electron beam generated by the electron source, and a control unit that controls the electron source and the optical system, the optical system being in a state in which an image is not moved at a center of a Ronchigram even when an acceleration voltage for accelerating the electron beam is fluctuated, and the control unit performing processing of: inserting the aperture into a path of the electron beam; setting the acceleration voltage to a first voltage value and obtaining a first STEM image, in a state in which the aperture is inserted; setting the acceleration voltage to a second voltage value that is different from the first voltage value and obtaining a second STEM image, in a state in which the aperture is inserted; and moving the aperture based on position deviation between the first STEM image and the second STEM image.

## Description

### BACKGROUND OF THE INVENTION

### Field of the Invention

The present invention relates to a scanning transmission electron microscope and an aligning method of an aperture.

### Description of Related Art

A scanning transmission electron microscope (STEM) is an apparatus that forms an electron probe by condensing an electron beam generated by an electron source, scans a specimen by the electron probe, and obtains a scanning transmission electron microscope image (STEM image) by detecting an electron transmitted through the specimen.

In the scanning transmission electron microscope, a Ronchigram is used for adjustment of an optical system such as axis adjustment, aberration correction and the like. The Ronchigram is a projected image (figure) of a specimen formed on a diffraction surface by condensing an electron beam at the vicinity of the specimen in the scanning transmission electron microscope.

In the scanning transmission electron microscope, in order to make the aberration of an illumination system smaller, the center of the aperture of the illumination system is aligned with the center of the Ronchigram. The aligning method of the aperture as described above is disclosed in JP 2021-176143 A, for example.

In the aligning method of the aperture disclosed in JP 2021-176143 A, the Ronchigram is formed by using an amorphous region of a specimen, the aperture is moved while checking the Ronchigram, and the center of the aperture is aligned with the center of the Ronchigram. In the aligning method of the aperture disclosed in JP. 2021-176143 A, the Ronchigram needs to be formed in the amorphous region of the specimen, each time the aperture is aligned by inserting the aperture.

### SUMMARY OF THE INVENTION

According to a first aspect of the present disclosure, there is provided a scanning transmission electron microscope including:
an electron source that generates an electron beam;
an optical system that has a condenser lens, an aperture, and an objective lens and forms an electron probe by condensing the electron beam generated by the electron source; and
a control unit that controls the electron source and the optical system,
the optical system being in a state in which an image is not moved at a center of a Ronchigram even when an acceleration voltage for accelerating the electron beam is fluctuated, and
the control unit performing processing of:
   inserting the aperture into a path of the electron beam;
   setting the acceleration voltage to a first voltage value and obtaining a first STEM image, in a state in which the aperture is inserted;
   setting the acceleration voltage to a second voltage value that is different from the first voltage value and obtaining a second STEM image, in a state in which the aperture is inserted; and
   moving the aperture based on position deviation between the first STEM image and the second STEM image.

According to a second aspect of the present disclosure, there is provided a scanning transmission electron microscope including:
an electron source that generates an electron beam;
an optical system that has a condenser lens, an aperture, and an objective lens and
forms an electron probe by focusing the electron beam generated by the electron source; and
   a control unit that controls the optical system,
   the optical system being in a state in which an image is not moved at a center of a Ronchigram even when an excitation current of the objective lens is fluctuated, and
   the control unit performing processing of:
      inserting the aperture into a path of the electron beam;
      setting the excitation current to a first current value and obtaining a first STEM image, in a state in which the aperture is inserted;
      setting the excitation current to a second current value that is different from the first current value and obtaining a second STEM image, in a state in which the aperture is inserted; and
      moving the aperture based on position deviation between the first STEM image and the second STEM image.
      According to a third aspect of the present disclosure, there is provided an aligning method of an aperture in a scanning transmission electron microscope that includes: an electron source that generates an electron beam; and an optical system that has a condenser lens, an aperture, and an objective lens and forms an electron probe by condensing the electron beam generated by the electron source,
      the method including:
         inserting the aperture into a path of the electron beam in a state in which an image is not moved at a center of a Ronchigram even when the optical system fluctuates an acceleration voltage for accelerating the electron beam;
         setting the acceleration voltage to a first voltage value and obtaining a first STEM image, in a state in which the aperture is inserted;
         setting the acceleration voltage to a second voltage value that is different from the first voltage value and obtaining a second STEM image, in a state in which the aperture is inserted; and
         moving the aperture based on position deviation between the first STEM image and the second STEM image.

According to a fourth aspect of the present disclosure, there is provided an aligning method of an aperture in a scanning transmission electron microscope that includes: an electron source that generates an electron beam; and an optical system that has a condenser lens, an aperture, and an objective lens and forms an electron probe by condensing the electron beam generated by the electron source,
the method including:
inserting the aperture into a path of the electron beam in a state in which an image is not moved at a center of a Ronchigram even when the optical system fluctuates an excitation current of the objective lens;
setting the excitation current to a first current value and obtaining a first STEM image, in a state in which the aperture is inserted;
setting the excitation current to a second current value that is different from the first current value and obtaining a second STEM image, in a state in which the aperture is inserted; and
moving the aperture based on position deviation between the first STEM image and the second STEM image.

### BRIEF DESCRIPTION OF THE DRAWINGS

FIG. 1 is a diagram illustrating an example of a configuration of a scanning transmission electron microscope according to the first embodiment.
FIG. 2 illustrates a state in which an aperture is inserted so that the center of the aperture is aligned with an optical axis of an illumination system in a state in which the optical axis of the illumination system is aligned with the center of a Ronchigram.
FIG. 3 illustrates a state in which the aperture is inserted so that the center of the aperture is aligned with the optical axis of the illumination system in a state in which the optical axis of the illumination system is deviated from the center of the Ronchigram.
FIG. 4 is a flowchart illustrating an example of an aligning method of an aperture.
FIG. 5 illustrates Ronchigrams before and after an acceleration voltage is changed, photographed in a state in which an optical axis of an illumination system is aligned with the center of the Ronchigrams.
FIG. 6 illustrates Ronchigrams before and after an acceleration voltage is changed, photographed in a state in which an optical axis of an illumination system is deviated from the center of the Ronchigrams.
FIG. 7 illustrates STEM images before and after an acceleration voltage is changed, photographed in a state in which the center of an aperture is aligned with the center of a Ronchigram.
FIG. 8 illustrates STEM images before and after an acceleration voltage is changed, photographed in a state in which the center of an aperture is deviated from the center of a Ronchigram.
FIG. 9 illustrates a state in which the center of an aperture is aligned with the center of a Ronchigram.
FIG. 10 illustrates a state in which the center of an aperture is deviated from the center of a Ronchigram.
FIG. 11 is a flowchart illustrating an example of aligning processing of an aperture of a control unit.
FIG. 12 is a flowchart illustrating an example of an aligning method of an aperture.
FIG. 13 is a flowchart illustrating an example of aligning processing of an aperture of a control unit.

### DESCRIPTION OF THE INVENTION

According to an embodiment of the present disclosure, there is provided a scanning transmission electron microscope including:
an electron source that generates an electron beam;
an optical system that has a condenser lens, an aperture, and an objective lens and forms an electron probe by condensing the electron beam generated by the electron source; and
a control unit that controls the electron source and the optical system,
the optical system being in a state in which an image is not moved at a center of a Ronchigram even when an acceleration voltage for accelerating the electron beam is fluctuated, and
the control unit performing processing of:
   inserting the aperture into a path of the electron beam;
   setting the acceleration voltage to a first voltage value and obtaining a first STEM image, in a state in which the aperture is inserted;
   setting the acceleration voltage to a second voltage value that is different from the first voltage value and obtaining a second STEM image, in a state in which the aperture is inserted; and
   moving the aperture based on position deviation between the first STEM image and the second STEM image.

In the scanning transmission electron microscope as above, since the center of the aperture can be aligned with the center of the Ronchigram by using the first STEM image and the second STEM image, there is no need to check the Ronchigram each time when the aperture is aligned. Thus, in the scanning transmission electron microscope as above, the aperture can be aligned easily.

According to an embodiment of the present disclosure, there is provided a scanning transmission electron microscope including:
an electron source that generates an electron beam;
an optical system that has a condenser lens, an aperture, and an objective lens and
forms an electron probe by focusing the electron beam generated by the electron source; and
   a control unit that controls the optical system,
   the optical system being in a state in which an image is not moved at a center of a Ronchigram even when an excitation current of the objective lens is fluctuated, and
   the control unit performing processing of:
      inserting the aperture into a path of the electron beam;
      setting the excitation current to a first current value and obtaining a first STEM image, in a state in which the aperture is inserted;
      setting the excitation current to a second current value that is different from the first current value and obtaining a second STEM image, in a state in which the aperture is inserted; and
      moving the aperture based on position deviation between the first STEM image and the second STEM image.

In the scanning transmission electron microscope as above, since the center of the aperture can be aligned with the center of the Ronchigram by using the first STEM image and the second STEM image, there is no need to check the Ronchigram each time when the aperture is aligned. Thus, in the scanning transmission electron microscope as above, the aperture can be aligned easily.

According to an embodiment of the present disclosure, there is provided an aligning method of an aperture in a scanning transmission electron microscope that includes: an electron source that generates an electron beam; and an optical system that has a condenser lens, an aperture, and an objective lens and forms an electron probe by condensing the electron beam generated by the electron source,
the method including:
inserting the aperture into a path of the electron beam in a state in which an image is not moved at a center of a Ronchigram even when the optical system fluctuates an acceleration voltage for accelerating the electron beam;
setting the acceleration voltage to a first voltage value and obtaining a first STEM image, in a state in which the aperture is inserted;
setting the acceleration voltage to a second voltage value that is different from the first voltage value and obtaining a second STEM image, in a state in which the aperture is inserted; and
moving the aperture based on position deviation between the first STEM image and the second STEM image.

In an aligning method of the aperture as above, since the center of the aperture can be aligned with the center of the Ronchigram by using the first STEM image and the second STEM image, there is no need to check the Ronchigram each time when the aperture is aligned. Thus, in the aligning method of the aperture as above, the center of the aperture can be aligned with the center of the Ronchigram easily.

According to an embodiment of the present disclosure, there is provided an aligning method of an aperture in a scanning transmission electron microscope that includes: an electron source that generates an electron beam; and an optical system that has a condenser lens, an aperture, and an objective lens and forms an electron probe by condensing the electron beam generated by the electron source,
the method including:
inserting the aperture into a path of the electron beam in a state in which an image is not moved at a center of a Ronchigram even when the optical system fluctuates an excitation current of the objective lens;
setting the excitation current to a first current value and obtaining a first STEM image, in a state in which the aperture is inserted;
setting the excitation current to a second current value that is different from the first current value and obtaining a second STEM image, in a state in which the aperture is inserted; and
moving the aperture based on position deviation between the first STEM image and the second STEM image.

In the aligning method of the aperture as above, since the center of the aperture can be aligned with the center of the Ronchigram by using the first STEM image and the second STEM image, there is no need to check the Ronchigram each time when the aperture is aligned. Thus, in the aligning method of the aperture as above, the center of the aperture can be aligned with the center of the Ronchigram easily.

Now preferred embodiments of the invention will be described in detail below with reference to the drawings. The embodiments described below do not unduly limit the contents of the invention described in the claims. Further, all of the components described below are not necessarily essential requirements of the invention.

### 1. First Embodiment

### 1.1 Scanning Transmission Electron Microscope

First, a scanning transmission electron microscope according to the first embodiment will be explained with reference to the drawings.

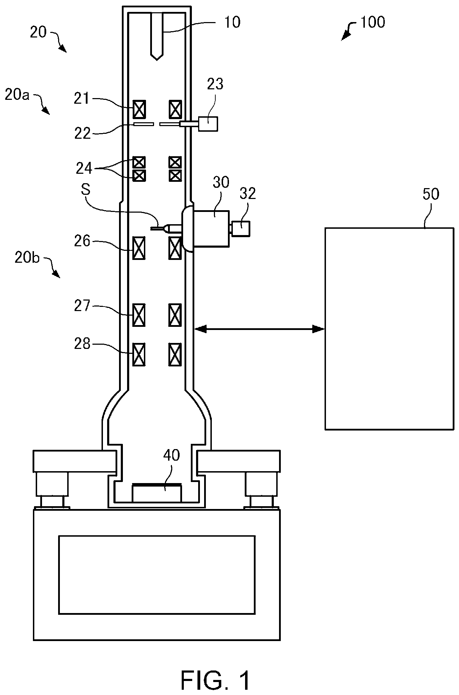

FIG. 1 is a diagram illustrating an example of a configuration of a scanning transmission electron microscope 100 according to the first embodiment.

The scanning transmission electron microscope 100 is an apparatus that scans a specimen S by an electron probe and detects an electron transmitted through the specimen S so as to obtain a scanning transmission electron microscope image (hereinafter, also referred to as a "STEM image"). Note that the scanning transmission electron microscope 100 includes a STEM mode for obtaining a STEM image and a TEM mode for obtaining a transmission electron microscope image (hereinafter, also referred to as a "TEM image").

The scanning transmission electron microscope 100 includes, as illustrated in FIG. 1, an electron source 10, an optical system 20, a specimen stage 30, a specimen holder 32, a detector 40, and a control unit 50.

The electron source 10 generates an electron beam. The electron source 10 is an electron gun which accelerates electrons emitted from a cathode at an anode and emits the electron beam. The electron beam generated by the electron source 10 is accelerated by a predetermined acceleration voltage. The acceleration voltage is a voltage for accelerating the electron beam generated by the electron source 10 and illuminating the specimen S. The acceleration voltage is controlled by the control unit 50.

The optical system 20 includes an illumination system 20a and an image forming system 20b. The illumination system 20a is an optical system which illuminates the specimen S with the electron beam emitted from the electron source 10. In the illumination system 20a, the electron beam emitted from the electron source 10 is focused so as to form an electron probe, and the specimen S can be scanned by the electron probe.

The illumination system 20a includes a condenser lens 21, an aperture 22, a scanning deflector 24, and an objective lens 26. The condenser lens 21 focuses the electron beam emitted from the electron source 10. The condenser lens 21 together with the objective lens 26 focus the electron beam and form the electron probe.

The aperture 22 is incorporated in the illumination system 20a. The aperture 22 cuts unnecessary electrons away from the optical axis of the illumination system 20a in order to reduce the aberration of the illumination system 20a and causes only the electron beam in the vicinity of the optical axis to pass through. The aperture 22 has a circular opening portion through which the electron beam is caused to pass formed in a metal plate, for example. The aperture 22 is disposed in the condenser lens 21, for example, that is, in a magnetic field functioning as the condenser lens 21.

The scanning transmission electron microscope 100 has a movement mechanism 23 for moving the aperture 22. The movement mechanism 23 moves the aperture 22 on a plane perpendicular to the optical axis of the illumination system 20a. By moving the aperture 22 by the movement mechanism 23, the aperture 22 can be inserted into a path of the electron beam, or the aperture 22 can be removed from the path of the electron beam.

The scanning deflector 24 two-dimensionally deflects the electron beam emitted from the electron source 10. By deflecting the electron beam by the scanning deflector 24, the specimen S can be scanned by the electron probe.

The objective lens 26 forms a TEM image in the TEM mode, and in the STEM mode, focuses the electron beam and forms an electron probe. The objective lens 26 forms a front magnetic field in front of the specimen S (on the condenser lens 21 side) and forms a rear magnetic field on the rear of the specimen S (on an intermediate lens 27 side). On a rear-focus surface of the objective lens 26, an electron diffraction pattern, a Ronchigram and the like are formed.

The scanning transmission electron microscope 100 does not include an aberration corrector for correcting spherical aberration of the illumination system 20a. Thus, in the scanning transmission electron microscope 100, the spherical aberration of the illumination system 20a cannot be corrected.

Note that the illumination system 20a may include optical elements such as a lens, an aperture, a deflector and the like other than the condenser lens 21, the aperture 22, the scanning deflector 24, and the objective lens 26.

The specimen stage 30 holds the specimen holder 32 for supporting the specimen S. The specimen stage 30 includes a movement mechanism for moving the specimen S, for example.

The image forming system 20b leads the electron beam transmitted through the specimen S to the detector 40. The image forming system 20b includes the objective lens 26, the intermediate lens 27, and a projection lens 28. The intermediate lens 27 changes a focal distance by adjusting an excitation current, focuses on the diffraction pattern or the TEM image formed by the objective lens 26, enlarges them and forms their images on an object surface of the projection lens 28. The projection lens 28 further enlarges the image enlarged by the intermediate lens 27 and forms an image on the detector 40.

Note that the image forming system 20b may include optical elements such as a lens, an aperture, a deflector and the like other than the objective lens 26, the intermediate lens 27, and the projection lens 28.

The detector 40 detects an electron transmitted through the specimen S. The detector 40 is a bright-field STEM detector, for example. The bright-field STEM detector detects electrons transmitted without being scattered and electrons scattered at small angles in the electron beam transmitted through the specimen S. Note that, though not shown, the scanning transmission electron microscope 100 may include an annular dark-field STEM detector which detects electrons scattered at high angles.

Though not shown, the scanning transmission electron microscope 100 includes an image pickup device for photographing a Ronchigram. The image pickup device is a digital camera capable of recording the Ronchigram as a two-dimensional digital image.

The control unit 50 controls each part of the scanning transmission electron microscope 100. The control unit 50 includes a processor such as a CPU (Central Processing Unit) and storage devices (memory) such as a RAM (Random Access Memory), a ROM (Read Only Memory) and the like. In the storage device, programs for executing various controls and data are stored. The functions of the control unit 50 can be realized by executing the program by the processor. The control unit 50 may be realized by general-purpose circuits such as a microcontroller, a microprocessor and the like operated in accordance with a program or may be realized by a dedicated circuit such as an ASIC (application specific integrated circuit), for example.

The control unit 50 performs processing of focusing, processing of correcting astigmatism, processing of adjusting gain and offset of the detector 40, processing of aligning the aperture 22 and the like. Therefore, the scanning transmission electron microscope 100 includes an autofocus function of automatic focusing, an automatic stigma function of automatically correcting astigmatism, an automatic gain / offset adjustment function of automatically adjusting gain and offset, and a function of automatically aligning the aperture 22.

The control unit 50 performs the processing of focusing, processing of correcting astigmatism, and processing of adjusting gain and offset by using publicly known methods. The processing of aligning the aperture 22 will be explained in "1.3 Aligning Processing of Aperture", which will be described later.

The scanning transmission electron microscope 100 includes the STEM mode of functioning as a scanning transmission electron microscope and the TEM mode of functioning as a transmission electron microscope.

In the STEM mode, the electron beam emitted from the electron source 10 is focused by the condenser lens 21 and the objective lens 26 and forms an electron probe on the specimen S, and is deflected by the scanning deflector 24. As a result, the specimen S is scanned by the electron probe. The image forming system 20b leads the electron beam transmitted through the specimen S to the detector 40, and the electron beam transmitted through the specimen S is detected by the detector 40. The STEM image can be obtained by synchronizing intensity of the electron beam detected by the detector 40 with the scanning of the electron probe.

In the TEM mode, the electron beam emitted from the electron source 10 is focused by the condenser lens 21 and emitted to the specimen S. The objective lens 26 forms a TEM image by the electron beam transmitted through the specimen S. The TEM image formed by the objective lens 26 is formed by an imaging device by the intermediate lens 27 and the projection lens 28. As a result, the TEM image can be obtained.

When the TEM mode is to be switched to the STEM mode in the scanning transmission electron microscope 100, adjustment of focusing, correction of astigmatism, adjustment of gain and offset of the detector 40, alignment of the aperture 22 and the like are performed. Since the scanning transmission electron microscope 100 includes the autofocus function, automatic stigma function, automatic gain / offset adjustment function, and the function of automatically aligning the aperture 22, adjustment of the optical system 20 when the TEM mode is switched to the STEM mode can be performed automatically,

### 1. 2 Alignment of Aperture

### 1. 2. 1. Principle

In the alignment of the aperture 22, the center of the aperture 22 is aligned with the center of the Ronchigram. The center of the aperture 22 is the center of the opening portion of the aperture 22.

The Ronchigram is a projected image (pattern) of the specimen S formed on the diffraction surface by condensing the electron beam to the vicinity of the specimen S. The Ronchigram is a diffraction pattern of the electron beam formed along the optical axis in the diffraction patterns of the electrons transmitted through the specimen S.

The Ronchigram corresponds to the electron probe. Thus, by aligning the center of the aperture 22 with the center of the Ronchigram, aberration can be made smaller, and the size of the electron probe can be reduced. As a result, resolution can be improved.

In the aligning method of the aperture 22 in the scanning transmission electron microscope 100, in a state where the optical axis of the illumination system 20a is aligned with the center of the Ronchigram, the center of the aperture 22 is aligned with the center of the Ronchigram by aligning the center of the aperture 22 with the optical axis of the illumination system 20a.

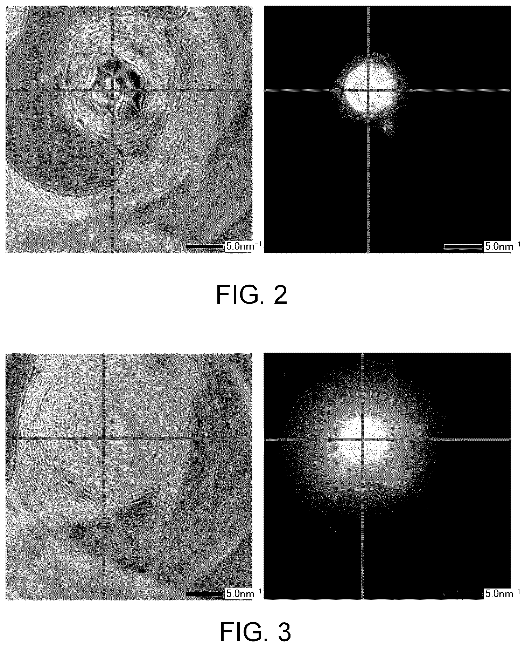

FIG. 2 illustrates a state in which the aperture 22 is inserted so that the center of the aperture 22 is aligned with the optical axis of the illumination system 20a in a state in which the optical axis of the illumination system 20a is aligned with the center of the Ronchigram. FIG. 3 illustrates a state in which the aperture 22 is inserted so that the center of the aperture 22 is aligned with the optical axis of the illumination system 20a in a state in which the optical axis of the illumination system 20a is deviated from the center of the Ronchigram.

Note that, FIG. 2 illustrates an image showing the state in which the optical axis of the illumination system 20a is aligned with the center of the Ronchigram and an image showing the state in which the aperture 22 is inserted so that the center of the aperture 22 is aligned with the optical axis of the illumination system 20a. In addition, in FIG. 3, an image illustrates an image showing the state in which the optical axis of the illumination system 20a is deviated from the center of the Ronchigram and an image showing the state in which the aperture 22 is inserted so that the center of the aperture 22 is aligned with the optical axis of the illumination system 20a. Note that, in FIG. 2 and FIG. 3, an intersection of two straight lines indicates the optical axis of the illumination system 20a.

As illustrated in FIG. 2, in a state in which the optical axis of the illumination system 20a is aligned with the center of the Ronchigram, the aperture 22 is moved so that the center of the aperture 22 is aligned with the optical axis of the illumination system 20a. As a result, the center of the aperture 22 can be aligned with the center of the Ronchigram.

Note that, as illustrated in FIG. 3, in a state in which the optical axis of the illumination system 20a is deviated from the center of the Ronchigram, the center of the aperture 22 is deviated from the center of the Ronchigram even if the aperture 22 is moved so that the center of the aperture 22 is aligned with the optical axis of the illumination system 20a.

Here, the optical axis of the illumination system 20a is a voltage center. When an acceleration voltage is fluctuated in the scanning transmission electron microscope 100, an image is enlarged / contracted concentrically. The center of the enlargement / contraction is the voltage center. In a state in which the optical axis of the illumination system 20a is at the center of the Ronchigram, when the acceleration voltage is fluctuated, the image is enlarged / contracted concentrically around the center of the Ronchigram. Therefore, in a state in which the optical axis of the illumination system 20a is aligned with the center of the Ronchigram, even if the acceleration voltage is fluctuated, the image is not moved at the center of the Ronchigram. By using this, the center of the aperture 22 can be aligned with the center of the Ronchigram. Hereinafter, the aligning method of the aperture 22 will be explained in detail.

### 1. 2. 2. Aligning Method of Aperture

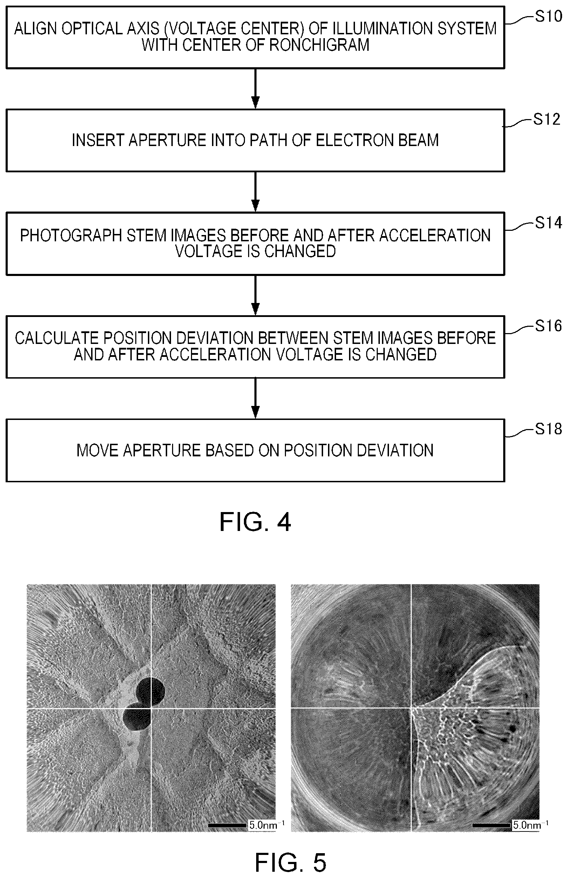

FIG. 4 is a flowchart illustrating an example of an aligning method of the aperture 22.

First, the optical system 20 is adjusted so that the image is not moved at the center of the Ronchigram even when the acceleration voltage is fluctuated, and the optical axis (voltage center) of the illumination system 20a is aligned with the center of the Ronchigram (Step S10).

Specifically, first, the optical system 20 is brought to a state in which the Ronchigram can be observed, and the center of the Ronchigram is confirmed. Subsequently, the Ronchigrams before and after the acceleration voltage is changed are observed, and the illumination system 20a is adjusted so that the image is not moved at the center of the Ronchigram even when the acceleration voltage is changed. For example, the optical axis of the illumination system 20a is aligned with the center of the Ronchigram by deflecting the electron beam by the deflector incorporated in the illumination system 20a. By adjusting the illumination system 20a so that the image is not moved at the center of the Ronchigram even when the acceleration voltage is changed, the optical axis of the illumination system 20a can be aligned with the center of the Ronchigram.

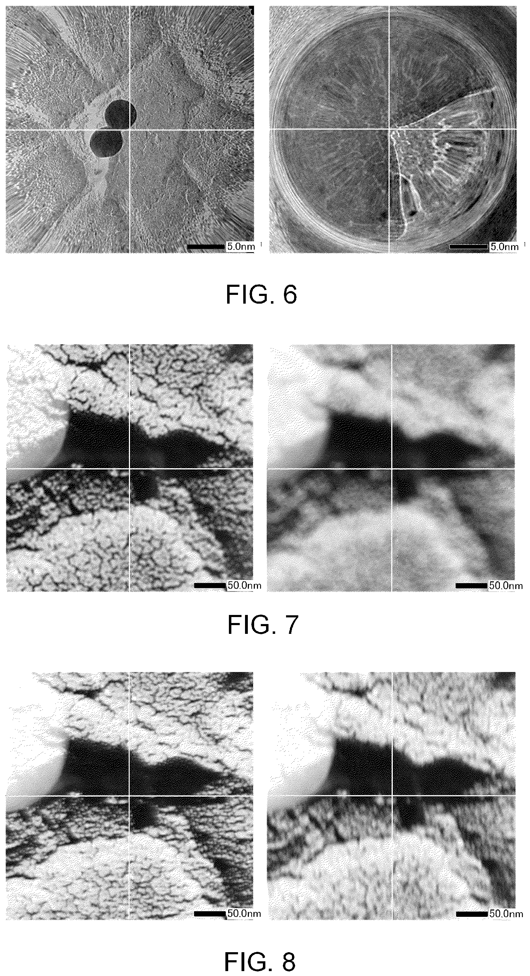

FIG. 5 illustrates the Ronchigrams before and after the acceleration voltage is changed, photographed in a state in which the optical axis of the illumination system 20a is aligned with the center of the Ronchigram. FIG. 6 illustrates the Ronchigrams before and after the acceleration voltage is changed, photographed in a state in which the optical axis of the illumination system 20a is deviated from the center of the Ronchigram.

As illustrated in FIG. 5, in a state in which the optical axis of the illumination system 20a is aligned with the center of the Ronchigram, the image is not moved before and after the acceleration voltage is changed. On the other hand, as illustrated in FIG. 6, in a state in which the optical axis of the illumination system 20a is deviated from the center of the Ronchigram, the image is moved before and after the acceleration voltage is changed. Therefore, as illustrated in FIG. 5, the illumination system 20a is adjusted so that the image is not moved before and after the acceleration voltage is changed.

Note that the positional relation between the center of the Ronchigram and the optical axis of the illumination system 20a hardly changes. Therefore, once a work of aligning the optical axis of the illumination system 20a with the center of the Ronchigram, this work does not have to be performed after that.

Subsequently, in a state in which the optical axis of the illumination system 20a is aligned with the center of the Ronchigram, that is, in a state in which the image is not moved at the center of the Ronchigram even when the acceleration voltage is fluctuated, the aperture 22 is inserted into the path of the electron beam (Step S12).

Subsequently, the optical system 20 is brought to a state in which the STEM image can be photographed, and the STEM images before and after the acceleration voltage is changed are photographed (Step S14).

Specifically, first, the STEM image of the specimen S is photographed. A photographing place of the STEM image is not particularly limited as long as it is a region on the specimen S including the image to be a mark in a field of view. Subsequently, the acceleration voltage is changed, and the STEM image of the specimen S after the acceleration voltage is changed is photographed. A photographing condition of the STEM image before the acceleration voltage is changed and a photographing condition of the STEM image after the acceleration voltage is changed are assumed to be the same except a voltage value of the acceleration voltage.

Subsequently, the STEM images before and after the acceleration voltage is changed are compared, and a position deviation between the STEM images before and after the acceleration voltage is changed are calculated (Step S16). The position deviation between the STEM images before and after the acceleration voltage is changed includes an amount of the position deviation and the direction of the position deviation between the STEM images before and after the acceleration voltage is changed. For example, the amount of the position deviation between the STEM images before and after the acceleration voltage is changed is calculated by obtaining Cross-Correlation between two STEM images.

Subsequently, the aperture 22 is moved based on the position deviation between the STEM images before and after the acceleration voltage is changed (Step S18).

Specifically, first, the position deviation between the center of the aperture 22 and the center of the Ronchigram (that is, the optical axis of the illumination system 20a) is calculated from the position deviation between the STEM images before and after the acceleration voltage is changed. Here, the illumination system 20a is in a state in which the image is not moved at the center of the Ronchigram even when the acceleration voltage is changed. Thus, the position deviation between the STEM images before and after the acceleration voltage is changed corresponds to the position deviation between the center of the aperture 22 and the center of the Ronchigram. Therefore, the position deviation between the center of the aperture 22 and the center of the Ronchigram can be calculated from the position deviation between the STEM images before and after the acceleration voltage is changed.

Subsequently, from the position deviation between the center of the aperture 22 and the center of the Ronchigram, the movement amount and the moving direction of the aperture 22 that the center of the aperture 22 is aligned with the center of the Ronchigram are calculated. Here, the relation between the distance on the STEM image and the movement amount of the aperture 22 is calibrated in advance. Similarly, the relation between the direction on the STEM image and the moving direction of the aperture 22 is calibrated in advance. Thus, the movement amount and the moving direction of the aperture 22 is obtained by using the result of the calibration from the position deviation between the center of the aperture 22 and the center of the Ronchigram. Subsequently, in accordance with the obtained movement amount and moving direction of the aperture 22, the aperture 22 is moved. As a result, the aperture 22 can be moved so that the center of the aperture 22 is aligned with the center of the Ronchigram.

FIG. 7 illustrates the STEM images before and after the acceleration voltage is changed, photographed in a state in which the center of the aperture 22 is aligned with the center of the Ronchigram. FIG. 8 illustrates the STEM images before and after the acceleration voltage is changed, photographed in a state in which the center of the aperture 22 is deviated from the center of the Ronchigram.

As illustrated in FIG. 7, in a state in which the center of the aperture 22 is aligned with the center of the Ronchigram, the image is not moved before and after the acceleration voltage is changed. On the other hand, as illustrated in FIG. 8, in a state in which the center of the aperture 22 is deviated from the center of the Ronchigram, the image is moved before and after the acceleration voltage is changed.

Until the position deviation between the STEM images before and after the acceleration voltage is changed runs out, that is, until the center of the aperture 22 is aligned with the center of the Ronchigram, the photographing of the STEM images before and after the acceleration voltage is changed, the calculation of the position deviation, and the movement of the aperture 22 described above may be repeated.

By means of the processes described above, the center of the aperture 22 can be aligned with the center of the Ronchigram.

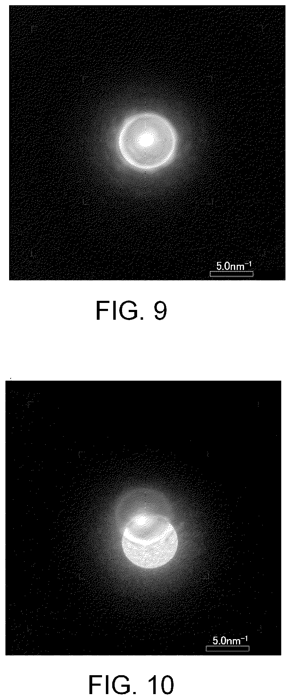

FIG. 9 illustrates a state in which the center of the aperture 22 is aligned with the center of the Ronchigram. FIG. 10 illustrates a state in which the center of the aperture 22 is deviated from the center of the Ronchigram. By means of the above-described aligning method of the aperture 22, as illustrated in FIG. 9, the center of the aperture 22 can be aligned with the center of the Ronchigram.

### 1. 3. Aligning Processing of Aperture

In the scanning transmission electron microscope 100, the optical system 20 is adjusted so that such a state that the optical axis (voltage center) of the illumination system 20a was at the center of the Ronchigram is brought about. That is, in the scanning transmission electron microscope 100, the optical system 20 is in a state in which the image is not moved at the center of the Ronchigram even when the acceleration voltage is fluctuated.

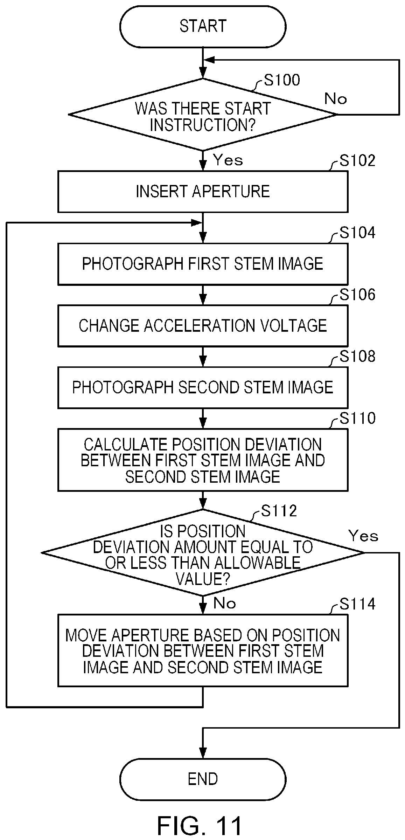

FIG. 11 is a flowchart illustrating an example of the aligning processing of the aperture 22 by the control unit 50.

The control unit 50 determines whether or not a user gave an instruction to start the aligning processing of the aperture 22 (Step S100). The control unit 50 determines, though not shown, that the user gave a start instruction when a pressing-down operation on a positioning start button of the GUI (Graphical User Interface) of the scanning transmission electron microscope 100 was performed or when the instruction to start aligning was input by an input device.

When the control unit 50 determined that the user gave the start instruction (Yes at Step S100), it causes the movement mechanism 23 to insert the aperture 22 into the path of the electron beam (Step S102). At this time, the control unit 50 disposes the aperture 22 at an initial position set in advance. The initial position may be a position of the aperture 22 determined by performing the aligning processing of the aperture 22 the previous time or may be an arbitrary set position, for example.

Subsequently, the control unit 50 sets the acceleration voltage to a first voltage value and photographs the first STEM image, in a state in which the aperture 22 is inserted (Step S104). The control unit 50 sets the acceleration voltage to the first voltage value, controls the optical system 20 to scan the specimen S with the electron probe. As a result, the first STEM image can be obtained. The first voltage value can be set to an arbitrary value. For example, in the case of the scanning transmission electron microscope with the acceleration voltage of 200 kV, the first voltage value may be 200 kV.

Subsequently, the control unit 50 changes the acceleration voltage from the first voltage value to a second voltage value (Step S106). The second voltage value is different from the first voltage value. The second voltage value is a value which can be set to an arbitrary value as long as it is a value different from the first voltage value. A change rate of the second voltage value with respect to the first voltage value is approximately 0.5%, for example.

Subsequently, the control unit 50 photographs the second STEM image in a state in which the aperture 22 is inserted (Step S108). The control unit 50 controls the optical system 20 and has the specimen S scanned by the electron probe. As a result, the second STEM image can be obtained. A photographing condition when the second STEM image is to be photographed is, except the point that the acceleration voltage is the second voltage value, the same as the photographing condition when the first STEM image is photographed.

Subsequently, the control unit 50 calculates the location deviation between the first STEM image and the second STEM image (Step S110). The control unit 50 calculates the position deviation amount by calculating the Cross-Correlation between the first STEM image and the second STEM image.

The control unit 50 determines whether or not the calculated position deviation amount is equal to or less than an allowable value (Step S112). The allowable value is set in accordance with the allowable position deviation amount between the center of the aperture 22 and the center of the Ronchigram. The allowable value can be set to an arbitrary value. For example, when the position deviation amount between the first STEM image and the second STEM image is expressed by a pixel number, the allowable value is also expressed by the pixel number.

When the control unit 50 determines that the position deviation amount is more than the allowable value (No at Step S112), that is, when it determines that the position deviation amount is larger than the allowable value, the control unit 50 causes the movement mechanism 23 to move the aperture 22 based on the position deviation amount (Step S114).

In the storage device of the control unit 50, a calibration result of a distance on the STEM image and a movement amount of the aperture 22 and a calibration result of the direction on the STEM image and the moving direction of the aperture 22 are stored. The control unit 50 calculates the movement amount and the moving direction of the aperture 22 from the position deviation between the first STEM image and the second STEM image by using these calibration results.

The control unit 50 causes the movement mechanism 23 to move the aperture 22 by the calculated movement amount and moving direction of the aperture 22. After the control unit 50 causes the movement mechanism 23 to move the aperture 22 (after Step S114), it returns to Step S104, set the acceleration voltage to the first voltage value, and causes the first STEM image to be photographed (Step S104).

The control unit 50 changes the acceleration voltage from the first voltage value to the second voltage value (Step S106), photographs the second STEM image (Step S108), and calculates the position deviation between the first STEM image and the second STEM image (Step S110).

The control unit 50 repeats the processing at Step S114, Step S104, Step S106, Step S108, Step S110, Step S112 until it is determined that the position deviation amount is equal to or less than the allowable value.

When it is determined that the position deviation amount is equal to or less than the allowable value (Yes at Step S112), the control unit 50 ends the aligning processing of the aperture 22.

By the control unit 50 performing the above-described aligning processing of the aperture 22, the center of the aperture 22 can be aligned with the center of the Ronchigram.

### 1.4. Effects

The scanning transmission electron microscope 100 has the electron source 10 which generates the electron beam, the condenser lens 21, the aperture 22, and the objective lens 26 and includes the optical system 20 which focuses the electron beam generated by the electron source 10 and forms the electron probe and the control unit 50 which controls the electron source 10 and the optical system 20. In addition, the optical system 20 is in a state in which the image is not moved at the center of the Ronchigram even when the acceleration voltage is fluctuated. In addition, the control unit 50 performs the processing of inserting the aperture 22 into the path of the electron beam, the processing of setting the acceleration voltage to the first voltage value and obtaining the first STEM image in a state in which the aperture 22 is inserted, the processing of setting the acceleration voltage to the second voltage value that is different from the first voltage value and obtaining the second STEM image in a state in which the aperture 22 is inserted, and the processing of moving the aperture 22 based on the position deviation between the first STEM image and the second STEM image.

Thus, in the scanning transmission electron microscope 100, by using the first STEM image and the second STEM image before and after the acceleration voltage is changed, the center of the aperture 22 can be aligned with the center of the Ronchigram. Thus, in the scanning transmission electron microscope 100, there is no need to check the Ronchigram each time when the position of the aperture 22 is aligned by inserting the aperture 22. Therefore, in the scanning transmission electron microscope 100, the aperture 22 can be aligned easily.

For example, when the aperture 22 is inserted, and the center of the aperture 22 is aligned with the center of the Ronchigram, while checking the center of the Ronchigram by the imaging device or visually, in order to check the center of the Ronchigram, the Ronchigram of the amorphous region of the specimen S is needed. In addition, the optical system 20 needs to be switched to such a condition that the Ronchigram can be observed.

On the other hand, in the scanning transmission electron microscope 100, the aperture 22 can be aligned by using the STEM image of an arbitrary region of the specimen S. That is, there is no need to check the Ronchigram each time when the aperture 22 is aligned. Therefore, in the scanning transmission electron microscope 100, the aperture 22 can be aligned easily. In addition, since there is no need to move to the amorphous region of the specimen S for the alignment of the aperture 22, a drift accompanying the movement of a field of view can be reduced.

In the scanning transmission electron microscope 100, since the control unit 50 aligns the center of the aperture 22 with the center of the Ronchigram by the user inputting an instruction to start the aligning processing of the aperture 22, the aperture 22 can be aligned easily.

Since the scanning transmission electron microscope 100 includes the autofocus function, automatic stigma function, automatic gain / offset adjustment function, and the function of automatically aligning the aperture 22, when the user switches the TEM mode to the STEM mode, there is no need to perform adjustment of focusing, astigmatism correction, adjustment of gain and offset of the detector 40, and the adjustment of the position of the aperture 22. Therefore, in the scanning transmission electron microscope 100, the user can obtain the STEM image easily after switching from the TEM mode to the STEM mode.

In the scanning transmission electron microscope 100, the control unit 50 calculates the position deviation between the center of the aperture 22 and the center of the Ronchigram from the position deviation between the first STEM image and the second STEM image in the processing of moving the aperture 22. Thus, in the scanning transmission electron microscope 100, the position deviation amount between the center of the aperture 22 and the center of the Ronchigram can be known without checking the Ronchigram.

In the scanning transmission electron microscope 100, the control unit 50 moves the aperture 22 so that the center of the aperture 22 is aligned with the center of the Ronchigram in the processing of moving the aperture 22. Thus, in the scanning transmission electron microscope 100, the aperture 22 can be easily aligned.

In the scanning transmission electron microscope 100, an aberration corrector for correcting the spherical aberration of the optical system 20 is not provided. Here, in the scanning transmission electron microscope without including the aberration corrector, since the spherical aberration is dominant, coma aberration cannot be checked. Thus, in the scanning transmission electron microscope as above, the shape of the Ronchigram cannot be checked. Therefore, it is difficult to align the center of the aperture 22 with the center of the Ronchigram while checking the center of the Ronchigram.

On the other hand, in the scanning transmission electron microscope 100, the center of the aperture 22 can be aligned with the center of the Ronchigram from the STEM images before and after the acceleration voltage is changed without checking the Ronchigram. Therefore, in the scanning transmission electron microscope 100, even without the aberration corrector, the center of the aperture 22 can be aligned with the center of the Ronchigram easily.

The aligning method of the aperture 22 in the scanning transmission electron microscope 100 includes: inserting the aperture 22 into the path of the electron beam, in a state in which the image is not moved at the center of the Ronchigram even if the optical system 20 fluctuates the acceleration voltage for accelerating the electron beam; setting the acceleration voltage to the first voltage value and obtaining the first STEM image, in a state in which the aperture 22 is inserted; setting the acceleration voltage to the second voltage value that is different from the first voltage value and obtaining the second STEM image, in a state in which the aperture 22 is inserted; and moving the aperture 22 based on the position deviation between the first STEM image and the second STEM image.

As described above, in this aligning method of the aperture 22, the center of the aperture 22 is aligned with the center of the Ronchigram by using the first STEM image and the second STEM image before and after the acceleration voltage is changed. Thus, in this aligning method of the aperture 22, there is no need to check the Ronchigram each time when the aperture 22 is inserted and the aperture 22 is aligned. Therefore, the aperture 22 can be aligned easily.

The aligning method of the aperture 22 in the scanning transmission electron microscope 100 includes, before inserting the aperture 22, adjusting the optical system 20 so that the image is not moved at the center of the Ronchigram even if the acceleration voltage is fluctuated. By means of this step, the optical system 20 can be brought to a state in which the optical axis of the illumination system 20a is aligned with the center of the Ronchigram.

In the aligning method of the aperture 22 in the scanning transmission electron microscope 100, in moving the aperture 22, the position deviation between the center of the aperture 22 and the center of the Ronchigram is calculated from the position deviation between the first STEM image and the second STEM image. Thus, in this aligning method of the aperture 22, the position deviation between the center of the aperture 22 and the center of the Ronchigram can be calculated without checking the Ronchigram.

In the aligning method of the aperture 22 in the scanning transmission electron microscope 100, in moving the aperture 22, the aperture 22 is moved so that the center of the aperture 22 is aligned with the center of the Ronchigram. Thus, the aperture 22 can be aligned easily.

### 2. Second Embodiment

### 2. 1. Scanning transmission electron microscope

Subsequently, a scanning transmission electron microscope according to the second embodiment will be explained. A configuration of the scanning transmission electron microscope according to the second embodiment is similar to the configuration of the scanning transmission electron microscope 100 according to the first embodiment in FIG. 1 described above, and the explanation thereof will be omitted.

### 2. 2. Alignment of Aperture

### 2. 2. 1. Principle

In the above-described first embodiment, regarding the alignment of the aperture 22, such a state that the optical axis of the illumination system 20a is aligned with the center of the Ronchigram is brought about, and by aligning the center of the aperture 22 with the optical axis of the illumination system 20a, the center of the aperture 22 is aligned with the center of the Ronchigram. Here, in the first embodiment, the optical axis of the optical system 20 was the voltage center. On the other hand, in the second embodiment, the optical axis of the optical system 20 is an objective current center.

When an excitation current of the objective lens 26 is fluctuated, the image is enlarged / contracted concentrically. The center of the enlargement / contraction is the objective current center. That is, in the second embodiment, the objective current center of the illumination system 20a is aligned with the center of the Ronchigram. In a state in which the optical axis of the illumination system 20a is aligned with the center of the Ronchigiram, when the excitation current of the objective lens 26 is fluctuated, the image is enlarged / contracted concentrically with the center of the Ronchigram as the center. Thus, in a state in which the optical axis of the illumination system 20a is aligned with the center of the Ronchigram, even if the excitation current of the objective lens 26 is fluctuated, the image is not moved at the center of the Ronchigram. By using this, the center of the aperture 22 can be aligned with the center of the Ronchigram.

Hereinafter, the aligning method of the aperture 22 will be explained in detail. Note that for points similar to those of the aligning method of the aperture 22 in the above-described first embodiment, explanation will be omitted.

### 2. 2. 2. Aligning Method of Aperture

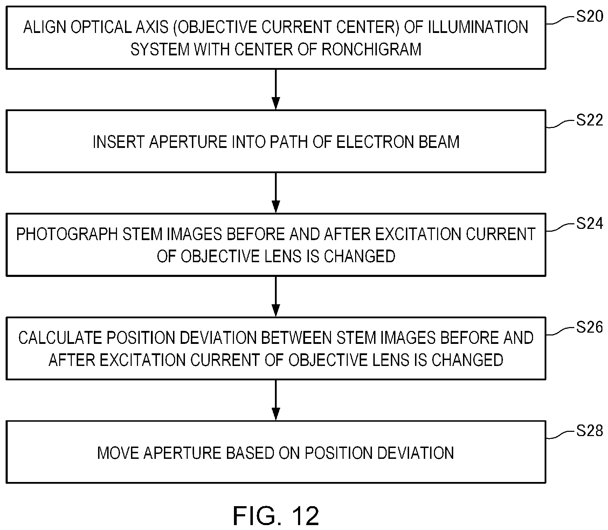

FIG. 12 is a flowchart illustrating an example of the aligning method of the aperture 22.

First, the optical system 20 is adjusted so that the image is not moved at the center of the Ronchigram even when the excitation current of the objective lens 26 is fluctuated, and the optical axis (objective current center) of the illumination system 20a is aligned with the center of the Ronchigram (Step S20).

Specifically, first, the optical system 20 is brought to a state in which the Ronchigram can be observed, and the center of the Ronchigram is checked. Subsequently, the Ronchigram before and after the excitation current of the objective lens 26 is changed is observed, and the illumination system 20a is adjusted so that the image is not moved at the center of the Ronchigram even when the excitation current of the objective lens 26 is changed. For example, by deflecting the electron beam by the deflector incorporated in the illumination system 20a, the optical axis of the illumination system 20a can be aligned with the center of the Ronchigram. The optical axis of the illumination system 20a can be aligned with the center of the Ronchigram by adjusting the illumination system 20a so that the image is not moved at the center of the Ronchigram even when the excitation current of the objective lens 26 is changed.

Note that the positional relation between the center of the Ronchigram and the optical axis of the illumination system 20a is rarely changed. Thus, only by performing the work of aligning the optical axis of the illumination system 20a with the center of the Ronchigram once, this work does not have to be performed any more after that.

Subsequently, in a state in which the optical axis of the illumination system 20a is aligned with the center of the Ronchigram, that is, in a state in which the image is not moved at the center of the Ronchigram even when the excitation current of the objective lens 26 is fluctuated, the aperture 22 is inserted into the path of the electron beam (Step S22).

Subsequently, the optical system 20 is brought to a state in which the STEM image can be photographed, and the STEM image before and after the excitation current of the objective lens 26 is changed is photographed (Step S24).

Specifically, first, the STEM image of the specimen S is photographed. Subsequently, the excitation current of the objective lens 26 is changed, and the STEM image of the specimen S after the excitation current of the objective lens 26 is changed is photographed. The photographing condition of the STEM image before the excitation current of the objective lens 26 is changed and the photographing condition of the STEM image after the excitation current of the objective lens 26 is changed are assumed to be the same except the current value of the excitation current of the objective lens 26.

Subsequently, the STEM images before and after the excitation current of the objective lens 26 is changed are compared, and the position deviation between the STEM images before and after the excitation current of the objective lens 26 is changed is calculated (Step S26). The position deviation between the STEM images before and after the excitation current of the objective lens 26 is changed includes an amount of the position deviation and a direction of the position deviation between the STEM images before and after the excitation current of the objective lens 26 is changed.

Subsequently, based on the position deviation between the STEM images before and after the excitation current of the objective lens 26 is changed, the aperture 22 is moved (Step S28).

Specifically, first, the position deviation between the center of the aperture 22 and the center of the Ronchigram is calculated from the position deviation between the STEM images before and after the excitation current of the objective lens 26 is changed. Here, the illumination system 20a is in a state in which the image is not moved at the center of the Ronchigram even when the excitation current of the objective lens 26 is changed. Thus, the position deviation between the STEM images before and after the excitation current of the objective lens 26 is changed corresponds to the position deviation between the center of the aperture 22 and the center of the Ronchigram. Therefore, from the position deviation between the STEM images before and after the excitation current of the objective lens 26 is changed, the position deviation between the center of the aperture 22 and the center of the Ronchigram can be calculated.

Subsequently, from the position deviation between the center of the aperture 22 and the center of the Ronchigram, a movement amount and a moving direction of the aperture 22 that the center of the aperture 22 is aligned with the center of the Ronchigram are calculated. The calculation of the movement amount and the moving direction of the aperture 22 is performed similarly to the above-described Step S18.

Until the position deviation between the STEM images before and after the excitation current of the objective lens 26 is changed is not present any more, that is, until the center of the aperture 22 is aligned with the center of the Ronchigram, the photographing of the STEM images before and after the excitation current of the objective lens 26 is changed, the calculation of the position deviation, and the movement of the aperture 22 described above may be repeated.

By means of the processes as above, the center of the aperture 22 can be aligned with the center of the Ronchigram.

### 2. 3. Aligning Processing of Aperture

In the scanning transmission electron microscope 100, the optical system 20 is adjusted so that the optical axis (objective current center) of the illumination system 20a is in a state of alignment with the center of the Ronchigram. That is, in the scanning transmission electron microscope 100, the optical system 20 is in a state in which the image is not moved at the center of the Ronchigram even when the excitation current of the objective lens 26 is fluctuated.

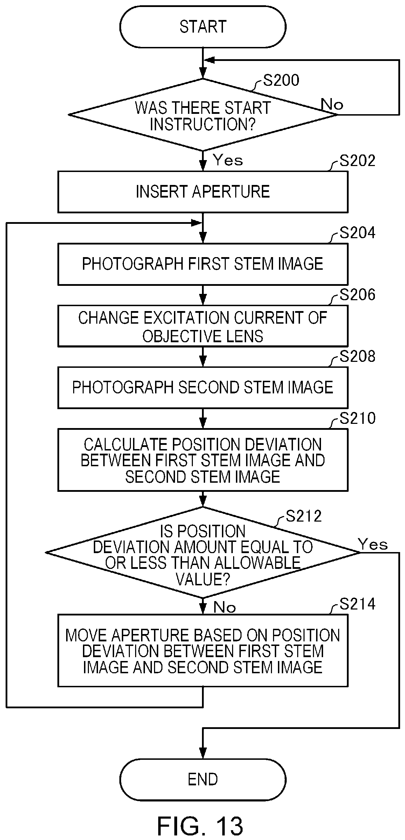

FIG. 13 is a flowchart illustrating an example of the aligning processing of the aperture 22 by the control unit 50. Note that explanation on the points similar to those in the aligning processing of the aperture 22 illustrated in FIG. 11 described above will be omitted.

The control unit 50 determines whether or not the user has given the instruction to start the aligning processing of the aperture 22 (Step S200). When it is determined that the user has given the start instruction (Yes at Step S200), the control unit 50 causes the movement mechanism 23 to insert the aperture 22 into the path of the electron beam (Step S202).

Subsequently, the control unit 50 sets the excitation current of the objective lens 26 to the first current value and photographs the first STEM image, in a state in which the aperture 22 is inserted (Step S204). The control unit 50 sets the excitation current of the objective lens 26 to the first current value and controls the optical system 20 to scan the specimen S with the electron probe. As a result, the first STEM image can be obtained. The first current value can be set to an arbitrary value.

Subsequently, the control unit 50 changes the excitation current of the objective lens 26 from the first current value to the second current value (Step S206). The second current value is different from the first current value. The second current value can be set to an arbitrary value as long as it is different from the first current value.

Subsequently, the control unit 50 photographs the second STEM image in a state in which the aperture 22 is inserted (Step S208). The control unit 50 controls the optical system 20 and has the specimen S scanned by the electron probe. As a result, the second STEM image can be obtained. The photographing condition when the second STEM image is photographed is the same as the photographing condition when the first STEM image is photographed except the point that the excitation current of the objective lens 26 is the second current value.

Subsequently, the control unit 50 calculates the position deviation between the first STEM image and the second STEM image (Step S210) and determines whether or not the calculated position deviation amount is equal to or less than the allowable value (Step S212).

When the control unit 50 determines that the position deviation amount is more than the allowable value (No at Step S212), it causes the movement mechanism 23 to move the aperture 22 based on the position deviation amount (Step S214).

After the control unit 50 causes the movement mechanism 23 to move the aperture 22 (after Step S214), returns to Step S204, sets the excitation current of the objective lens 26 to the first current value, and photographs the first STEM image (Step S204). The control unit 50 changes the excitation current of the objective lens 26 from the first current value to the second current value (Step S206), photographs the second STEM image (Step S208), and calculates the position deviation amount between the first STEM image and the second STEM image (Step S210).

The control unit 50 repeats the processing at Step S214, Step S204, Step S206, Step S208, Step S210, and Step S212 until the position deviation amount is determined to be equal to or less than the allowable value.

When it is determined that the position deviation amount is equal to or less than the allowable value (Yes at Step S212), the control unit 50 ends the aligning processing of the aperture 22.

By means of the control unit 50 performing the above-described aligning processing of the aperture 22, the center of the aperture 22 can be aligned with the center of the Ronchigram.

### 2. 4. Effects

In the scanning transmission electron microscope 100, the optical system 20 is in a state in which the image is not moved at the center of the Ronchigram even when the excitation current of the objective lens 26 is fluctuated. In addition, the control unit 50 performs: the processing of inserting the aperture 22 into the path of the electron beam; the processing of setting the excitation current of the objective lens 26 to the first current value and obtaining the first STEM image, in a state in which the aperture 22 is inserted; the processing of setting the excitation current of the objective lens 26 to the second current value that is different from the first current value and obtaining the second STEM image, in a state in which the aperture 22 is inserted; and the processing of moving the aperture 22 based on the position deviation between the first STEM image and the second STEM image.

Thus, in the scanning transmission electron microscope 100, by using the first STEM image and the second STEM image before and after the excitation current of the objective lens 26 is changed, the center of the aperture 22 can be aligned with the center of the Ronchigram. Therefore, in the scanning transmission electron microscope 100, the aperture 22 can be aligned easily.

The aligning method of the aperture 22 in the scanning transmission electron microscope 100 includes: inserting the aperture 22 into the path of the electron beam, in a state in which the image is not moved at the center of the Ronchigram even when the optical system 20 fluctuates the excitation current of the objective lens 26; setting the excitation current of the objective lens 26 to the first current value and obtaining the first STEM image, in a state in which the aperture 22 is inserted; setting the excitation current of the objective lens 26 to the second current value that is different from the first current value and obtaining the second STEM image, in a state in which the aperture 22 is inserted; and moving the aperture 22 based on the position deviation between the first STEM image and the second STEM image.

As described above, in this aligning method of the aperture 22, by using the first STEM image and the second STEM image before and after the excitation current of the objective lens 26 is changed, the center of the aperture 22 is aligned with the center of the Ronchigram. Thus, in this aligning method of the aperture 22, there is no need to check the Ronchigram each time when the aperture 22 is inserted and the aperture 22 is aligned. Therefore, the aperture 22 can be aligned easily.

The aligning method of the aperture 22 in the scanning transmission electron microscope 100 includes, before inserting the aperture 22, adjusting the optical system 20 so that the image is not moved at the center of the Ronchigram even when the excitation current of the objective lens 26 is fluctuated. By means of this step, the optical system 20 can be brought to a state in which the optical axis of the illumination system 20a is aligned with the center of the Ronchigram.

### 3. Modification

The above-described scanning transmission electron microscope 100 according to the first embodiment and the second embodiment includes the STEM mode for obtaining the STEM image and the TEM mode for obtaining the TEM image but may include only the STEM mode.

In addition, in the above-described first embodiment and the second embodiment, the case in which the scanning transmission electron microscope 100 does not include the aberration corrector for correcting spherical aberration was explained, but the scanning transmission electron microscope 100 may include the aberration corrector for correcting the spherical aberration.

The invention is not limited to the above-described embodiments, and various modifications can be made. For example, the invention includes configurations that are substantially the same as the configurations described in the embodiments. Substantially same configurations mean configurations having the same functions and methods, for example. The invention also includes configurations obtained by replacing non-essential elements of the configurations described in the embodiments with other elements. The invention further includes configurations obtained by adding known art to the configurations described in the embodiments.

## Claims

1. A scanning transmission electron microscope comprising:
an electron source that generates an electron beam;
an optical system that has a condenser lens, an aperture, and an objective lens and forms an electron probe by condensing the electron beam generated by the electron source; and
a control unit that controls the electron source and the optical system,
the optical system being in a state in which an image is not moved at a center of a Ronchigram even when an acceleration voltage for accelerating the electron beam is fluctuated, and
the control unit performing processing of:
inserting the aperture into a path of the electron beam;
setting the acceleration voltage to a first voltage value and obtaining a first STEM image, in a state in which the aperture is inserted;
setting the acceleration voltage to a second voltage that is different from the first voltage value and obtaining a second STEM image, in a state in which the aperture is inserted; and
moving the aperture based on position deviation between the first STEM image and the second STEM image.

2. A scanning transmission electron microscope comprising:
an electron source that generates an electron beam;
an optical system that has a condenser lens, an aperture, and an objective lens and forms an electron probe by focusing the electron beam generated by the electron source; and
a control unit that controls the optical system,
the optical system being in a state in which an image is not moved at a center of a Ronchigram even when an excitation current of the objective lens is fluctuated, and
the control unit performing processing of:
inserting the aperture into a path of the electron beam;
setting the excitation current to a first current value and obtaining a first STEM image, in a state in which the aperture is inserted;
setting the excitation current to a second current value that is different from the first current value and obtaining a second STEM image, in a state in which the aperture is inserted; and
moving the aperture based on position deviation between the first STEM image and the second STEM image.

3. The scanning transmission electron microscope according to claim 1 or 2, wherein
in the processing of moving the aperture, the control unit calculates position deviation between a center of the aperture and the center of the Ronchigram from the position deviation between the first STEM image and the second STEM image.

4. The scanning transmission electron microscope according to any one of claims 1 to 3, wherein
in the processing of moving the aperture, the control unit moves the aperture such that the center of the aperture is aligned with the center of the Ronchigram.

5. The scanning transmission electron microscope according to any one of claims 1 to 4, wherein
the control unit performs processing of determining whether or not an amount of the position deviation between the first STEM image and the second STEM image is equal to or less than an allowable value; and
when determination is made that the amount is more than the allowable value, the control unit performs the processing of moving the aperture.

6. The scanning transmission electron microscope according to any one of claims 1 to 5, wherein
an aberration corrector for correcting spherical aberration of the optical system is not provided.

7. An aligning method of an aperture in a scanning transmission electron microscope that includes: an electron source that generates an electron beam; and an optical system that has a condenser lens, an aperture, and an objective lens and forms an electron probe by condensing the electron beam generated by the electron source,
the method comprising:
inserting the aperture into a path of the electron beam, in a state in which an image is not moved at a center of a Ronchigram even when the optical system fluctuates an acceleration voltage for accelerating the electron beam;
setting the acceleration voltage to a first voltage value and obtaining a first STEM image, in a state in which the aperture is inserted;
setting the acceleration voltage to a second voltage value that is different from the first voltage value and obtaining a second STEM image, in a state in which the aperture is inserted; and
moving the aperture based on position deviation between the first STEM image and the second STEM image.

8. The aligning method according to claim 7, further comprising:
before inserting the aperture, adjusting the optical system such that an image is not moved at the center of the Ronchigram even when the acceleration voltage is fluctuated.

9. An aligning method of an aperture in a scanning transmission electron microscope that includes: an electron source that generates an electron beam; and an optical system that has a condenser lens, an aperture, and an objective lens and forms an electron probe by condensing the electron beam generated by the electron source,
the method comprising:
inserting the aperture into a path of the electron beam, in a state in which an image is not moved at a center of a Ronchigram even when the optical system fluctuates an excitation current of the objective lens;
setting the excitation current to a first current value and obtaining a first STEM image, in a state in which the aperture is inserted;
setting the excitation current to a second current value that is different from the first current value and obtaining a second STEM image, in a state, in which the aperture is inserted; and
moving the aperture based on position deviation between the first STEM image and the second STEM image.

10. The aligning method according to claim 9, further comprising:
before inserting the aperture, adjusting the optical system such that an image is not moved at the center of the Ronchigram even when the excitation current is fluctuated.

11. The aligning method according to any one of claims 7 to 10, wherein
in moving the aperture, position deviation between a center of the aperture and the center of the Ronchigram is calculated from the position deviation between the first STEM image and the second STEM image.

12. The aligning method according to any one of claims 7 to 11, wherein
in moving the aperture, the aperture is moved such that the center of the aperture is aligned with the center of the Ronchigram.

13. The aligning method according to any one of claims 7 to 12, wherein
the scanning transmission electron microscope does not comprise an aberration corrector for correcting spherical aberration of the optical system.
